(19) **Europäisches Patentamt European Patent Office Office européen des brevets**

(11) **EP 0 926 823 B1**

(12) **FASCICULE DE BREVET EUROPEEN**

(45) Date de publication et mention
de la délivrance du brevet:
**18.07.2007 Bulletin 2007/29**

(51) Int Cl.:
***H03H 17/02*** *(2006.01)*

(21) Numéro de dépôt: **98204272.3**

(22) Date de dépôt: **16.12.1998**

(54) **Circuit programmable pour réaliser un filtre numérique**

Programmierbare Schaltung zur Realisierung eines digitalen Filters

Programmable circuit for the realisation of a digital filter

(84) Etats contractants désignés:
**DE FR GB IT**

(30) Priorité: **23.12.1997 FR 9716306**

(43) Date de publication de la demande:
**30.06.1999 Bulletin 1999/26**

(73) Titulaire: **Koninklijke Philips Electronics N.V.
5621 BA Eindhoven (NL)**

(72) Inventeurs:
• **Dujardin, Eric
75008 Paris (FR)**
• **Gay-Bellile, Olivier
75008 Paris (FR)**

(74) Mandataire: **van Oudheusden-Perset, Laure E. et al
Société Civile SPID
156, Boulevard Haussmann
75008 Paris (FR)**

(56) Documents cités:
**EP-A- 0 732 809**

• **THIRION: "MULTIPLEX DIGITAL FILTERING TECHNIQUE" IBM TECHNICAL DISCLOSURE BULLETIN., vol. 16, no. 12, mai 1974, pages 3942-3943, XP002076784 NEW YORK US**

**Description**

La présente invention concerne un circuit co-processeur programmable destiné à être associé à un processeur principal pour constituer un filtre numérique, circuit comprenant plusieurs éléments processeurs de filtrage commandés par un bloc de commande et contenant chacun un registre de données d'entrée dont une sortie de lecture est reliée à une entrée d'au moins un additionneur, au moins un multiplieur dont une entrée est connectée à une sortie de résultat de l'additionneur et une autre entrée est connectée à une sortie de lecture d'une mémoire de coefficients, et dont une sortie de résultat est reliée à une entrée d'un additionneur dit final dont une sortie fournit un résultat intermédiaire du calcul d'une équation à chaque cycle d'une horloge.

Un tel circuit est utilisé notamment dans des applications où plusieurs filtres sont nécessaires, telles que diverses applications dites "multimédia", par exemple pour réduire les interférences inter-symboles, pour changer le débit de données, ou pour réduire le bruit ajouté par un canal de communication.

Un filtre numérique comprend essentiellement une suite d'éléments entre lesquels sont prélevés des signaux qui sont traités, notamment multipliés par un coefficient et/ou additionnés, puis sont ré-injectés ailleurs. Pour réaliser des filtres numériques, on connaît trois voies :

- utiliser un processeur, du genre dit DSP, avec des algorithmes spécialisés de façon à constituer un filtre ; si cette voie offre une grande flexibilité, elle est par contre limitée du point de vue des performances des filtres, notamment en vitesse,

- utiliser des circuits spécialisés constituant directement des filtres ; cela permet de grandes performances mais conduit à développer de nombreux circuits différents,

- utiliser des circuits spécialisés, mais programmables ; cela procure un bon compromis entre les performances élevées des circuits spécialisés et la bonne flexibilité d'un DSP ; parmi les circuits spécialisés programmables, on distingue des filtres programmables à processeur, cela signifie qu'ils sont essentiellement constitués par un processeur DSP réduit au minimum requis par le processus mis en oeuvre dans un filtre. C'est la solution la plus intéressante.

Un circuit spécialisé programmable comprend des registres pour stocker des coefficients programmables. Il est en général configuré pour réaliser un type de filtre particulier : symétrique, demi-bande, d'interpolation, à décimation, adaptatif, complexe. Un filtre programmable à processeur est connu du document EP 0 732 809. Le processeur selon ce document est capable de calculer deux filtres montés en cascade, ayant la même fréquence d'horloge. Il utilise deux registres pour stocker les résultats partiels des deux filtres.

Un objet de l'invention est de fournir un circuit programmable qui permette le multiplexage de différents types de filtres, même quand ils ont différents formats de données, et différentes vitesses pour l'entrée des données.

A cet effet, pour multiplexer une pluralité de filtres différents ayant différents formats de données et différentes vitesses pour l'entrée des données, chaque élément processeur de filtrage comprend un nombre de registres de résultats partiels égal au nombre de filtres différents que l'on désire pouvoir multiplexer, une entrée d'écriture de chaque registre est connectée à la sortie de l'additionneur final, et une sortie de lecture de chaque registre est connectée à une des entrées de l'additionneur final.

Ainsi, plusieurs filtres ayant des formats différents de données, réelles ou complexes, peuvent être traités.

D'autres modes particuliers de réalisation de l'invention apparaissent dans les revendications 2 à 8.

Ces aspects de l'invention ainsi que d'autres aspects plus détaillés apparaîtront plus clairement grâce à la description suivante d'un mode de réalisation constituant un exemple non limitatif.

La figure 1 représente schématiquement un système de calcul de filtres.
La figure 2 est un schéma plus détaillé d'un élément processeur de filtrage
La figure 3 est un diagramme illustrant la progression d'un calcul.
La figure 4 est un schéma d'un élément de mise à jour de l'élément processeur de filtrage de la figure 2.
La figure 5 représente schématiquement l'organisation d'un bloc de commande du circuit.

Pour réaliser des types différents de filtres, on part de filtres à réponse impulsionnelle finie : chaque type différent de filtre est en fait un filtre à réponse impulsionnelle finie ayant des propriétés qui résultent de la diminution ou de l'augmentation de la complexité d'un filtre standard. Les types de filtres que le circuit peut traiter sont les suivants :

- filtres symétriques : ils ont des coefficients symétriques ce qui permet d'importantes simplifications concernant les multiplieurs et les mémoires. En effet, pour un filtre de longueur L, seulement $\lceil 1\,L/2 \rceil$ coefficients, $\lceil L/2 \rceil$ multiplications et L-1 additions sont nécessaires. L'équation d'un filtre symétrique est :

$$y(n) = \sum_{k=0}^{\lceil \frac{L}{2} \rceil - 1} (x(n-k) + x(n-L-k+1)) \times w_k \qquad (1)$$

où x(i) est le signal d'entrée à l'instant i, n représente le temps rythmé par une horloge connue non représentée, k est le numéro d'un coefficient, et $w_k$ est un coefficient correspondant au coefficient k.

- filtres adaptatifs : ce sont des filtres capables de s'adapter à un canal de communication par adaptation de coefficients de façon à minimiser un signal d'erreur. L'équation d'un filtre adaptatif est :

$$y(n) = \sum_{k=0}^{L-1} x(n-k) \times w_k \qquad (2)$$

avec :

$$w_k(n+1) = w_k(n) - K \times e(n) \times x(n-k)^* \qquad (3)$$

où K correspond à l'étape d'adaptation, x(n-i)* est le complexe conjugué de x(n-i) si les données sont complexes, et e(n) est l'erreur sur le résultat. L'erreur est calculée par le processeur hôte. Cet algorithme utilise des multiplications complètes, et pour réduire la complexité, on utilise une version signée pour le calcul de l'erreur et pour celui des données, ce qui procure une meilleure vitesse de calcul :

$$w_k(n+1) = w_k(n) - K \times sgn\ (e(n)) \times sgn\ (x(n-k)^*) \qquad (4)$$

- filtres à décimation : ce sont des filtres dans lesquels le débit de données en sortie est plus bas que celui en entrée. L'équation d'un filtre à décimation est :

$$y(n) = \sum_{k=0}^{L-1} x(dn-k) \times w_k \qquad (5)$$

où d (entier) est le facteur de décimation.

En fin de compte, on peut définir une équation commune à tous les types de filtres possibles :

$$y(n) = \sum_{k=0}^{\ell-1} (x(dn-k) + x(dn-L+k+1)) \times w_k \qquad (6)$$

dans laquelle L est la longueur du filtre et $\ell$ le nombre de coefficients. Dans le cas d'un filtre non symétrique, le second terme (x(dn-L+k+1)) n'est pas utilisé.
Le format des données d'entrée peut être réel ou complexe, ceci valant aussi bien pour les coefficients, cela requiert de réaliser des opérations complexes. L'addition de deux données complexes requiert deux additions réelles, la multiplication d'une donnée complexe par un coefficient réel requiert deux multiplications réelles, et la multiplication de deux données complexes requiert quatre multiplications réelles et deux additions réelles.

Le nombre de données d'entrée et de valeurs de coefficients à mémoriser, ainsi que le nombre de multiplications et d'additions nécessité par les différents algorithmes correspondant à différents types de filtres à réponse impulsionnelle finie sont pris en considération pour définir l'architecture du circuit. Les filtres symétriques nécessitent deux fois plus d'additions que de multiplications alors que d'autres filtres utilisent le même nombre de multiplications et d'additions. Comme les filtres symétriques sont largement utilisés dans les communications numériques et que le surcoût marginal d'un additionneur est minime, une architecture optimisée pour les filtres symétriques est utilisée. Le problème du nombre de coefficients et de données est résolu par un partage des mémoires.

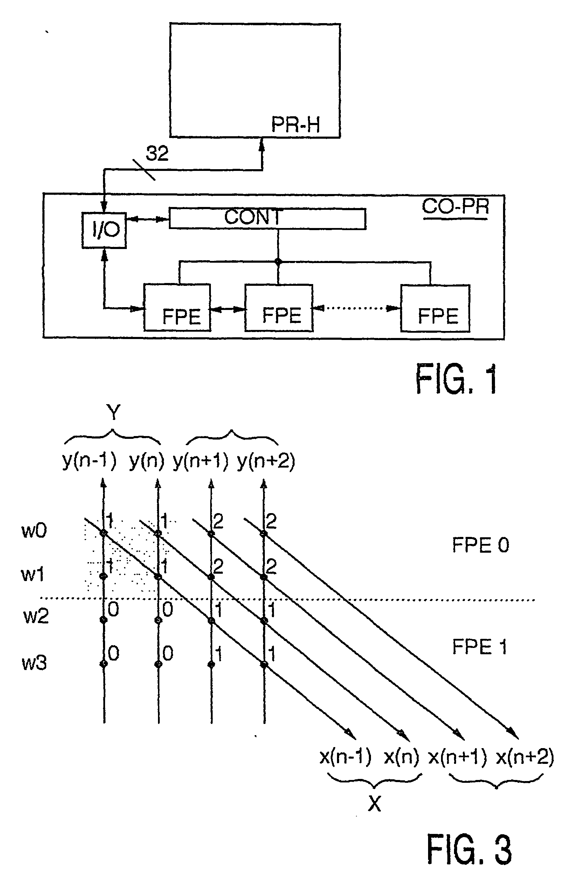

Le circuit CO-PR de la figure 1 est un co-processeur associé avec un processeur hôte PR-H, et il communique avec lui via un bus à 32 bits, même lorsque le filtre numérique ne nécessite pas autant de bits en parallèle. Il comprend un bloc I/O qui synchronise les communications entre le processeur hôte et le co-processeur, ainsi qu'un bloc de commande CONT qui enregistre les caractéristiques du filtre à réaliser et qui commande des éléments processeurs de filtrage FPE proprement dits. Plusieurs éléments processeurs de filtrage FPE sont prévus pour fournir la puissance de calcul nécessaire, leur nombre sera appelé $n_c$.

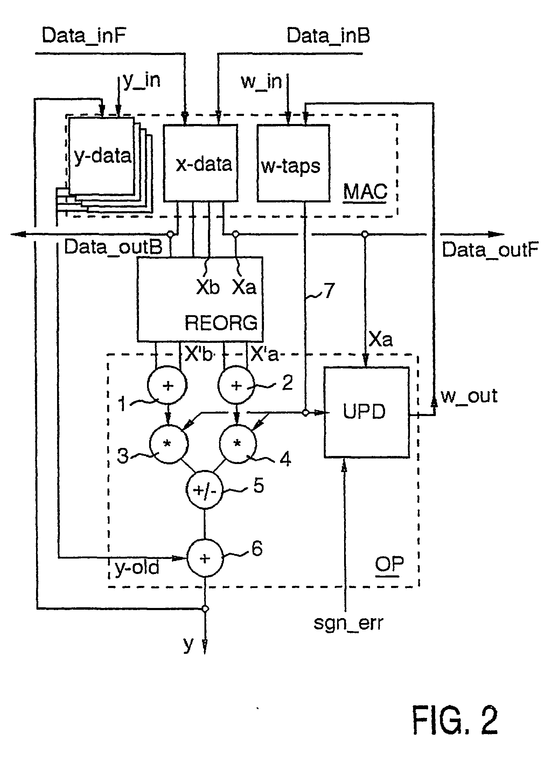

L'élément processeur de filtrage de la figure 2 comprend deux parties principales : une partie opératrice OP et une partie mémoire MAC. La partie opératrice contient les multiplieurs et additionneurs requis pour calculer les filtres et la logique utilisée pour mettre à jour les coefficients des filtres adaptatifs. La partie mémoire contient une mémoire w-taps, pour mémoriser tous les coefficients utilisés par les différents filtres multiplexés, une mémoire x-data pour mémoriser toutes les données d'entrée utilisées par les filtres, et un nombre NMF de registres y-data pour mémoriser les résultats partiels de MNF filtres. Les registres y-data sont particulièrement destinés au calcul avec multiplexage. L'entrée w_in sert à initialiser la mémoire w-taps.

Des données sont transmises par deux lignes unidirectionnelles entre éléments processeurs de filtrage : une ligne "aller" Data_inF et une ligne "retour" Data_inB. La ligne aller transmet des données de la gauche vers la droite. La ligne retour transmet des données de la droite vers la gauche ; cette ligne est utilisée seulement dans le cas de filtres symétriques. Les résultats sont transmis de la droite vers la gauche via les ports y_in et y.

Du fait qu'il y a plusieurs formats possibles pour les données, qu'une décimation peut être réalisée, et que les données peuvent être réelles ou complexes, un bloc de réorganisation de données REORG est prévu, muni de moyens pour recevoir des données d'entrée depuis la mémoire des données d'entrée x-data, pour les réorganiser et les fournir aux premiers et second additionneurs, de façon à alimenter la partie opératrice avec des données adéquates. Des données $X_a$ et $X_b$ venant du registre x-data, correspondant à celles transmises par la ligne aller, sont transformées en X'a et X'b par ce bloc de réorganisation.

La partie opératrice OP comprend un premier additionneur 1 et un second additionneur 2, chacun d'entre eux ayant sa sortie connectée à une entrée respectivement d'un premier multiplieur 3 et d'un second multiplieur 4 dont l'autre entrée reçoit, via une connexion 7, une valeur de coefficient depuis la mémoire des coefficients w-taps, et les sorties du premier et du second multiplieur sont connectées chacune à une entrée d'un additionneur/soustracteur 5 dont la sortie est connectée à une entrée d'un troisième additionneur 6, dit additionneur final, l'autre entrée de cet additionneur recevant d'un des registres de résultats partiels le résultat y-old obtenu au cycle précédent, et sa sortie délivrant le résultat de calcul "y" qui correspond au cycle courant. Ces deux additionneurs 1, 2, deux multiplieurs 3, 4 réalisent les accumulations et les multiplications requises pour le calcul de résultats partiels. Un bloc de mise à jour UPD sert à adapter les coefficients en cas de filtre adaptatif. Chaque multiplieur 3, 4 de 32 bits de précision peut être utilisé comme deux multiplieurs 16 bits, de façon à pouvoir traiter une multiplication complexe à 16 bits en un cycle, et chaque additionneur 1, 2 comprend deux additionneurs 16 bits. Des mots à 8 bits sont utilisables, chaque opérateur 16 bits pouvant être considéré comme deux opérateurs 8 bits. Ainsi un élément processeur de filtrage peut traiter jusqu'à vingt quatre opérations 8 bits simultanément. Chaque opérateur peut être considéré comme quatre opérateurs 8 bits ou comme deux opérateurs 16 bits en parallèle. Les deux additionneurs 1, 2 sont utilisés quand un filtre est symétrique ; ils sont court-circuités dans les autres cas. L'additionneur-soustracteur 5 est utilisé comme soustracteur lorsque cela est requis par une multiplication complexe, et comme additionneur dans les autres cas. Le bloc OP réalise l'équation suivante :

$$Y(new) = Y\text{-}old \div (X'a + X'aB) \times W_0 \pm (X'b + X'bB) \times w_1$$

où $\pm$ est soit une addition (dans le cas de coefficient réel, de parties en quadrature ou de multiplication complexe), soit une soustraction (dans le cas de parties en phase d'une multiplication complexe) ; $w_0$ et $w_1$ sont soit deux coefficients réels consécutifs, soit un coefficient complexe ; X'a et X'b sont des données d'entrée de la ligne aller ; X'aB et X'bB sont des données d'entrée de la ligne retour, leurs valeurs sont nulles si le filtre n'est pas symétrique ; y(new) est la valeur, calculée en dernier, du résultat partiel y, cependant que y-old est, soit la valeur précédente de y, soit le résultat partiel d'un autre élément processeur de filtrage y_in.

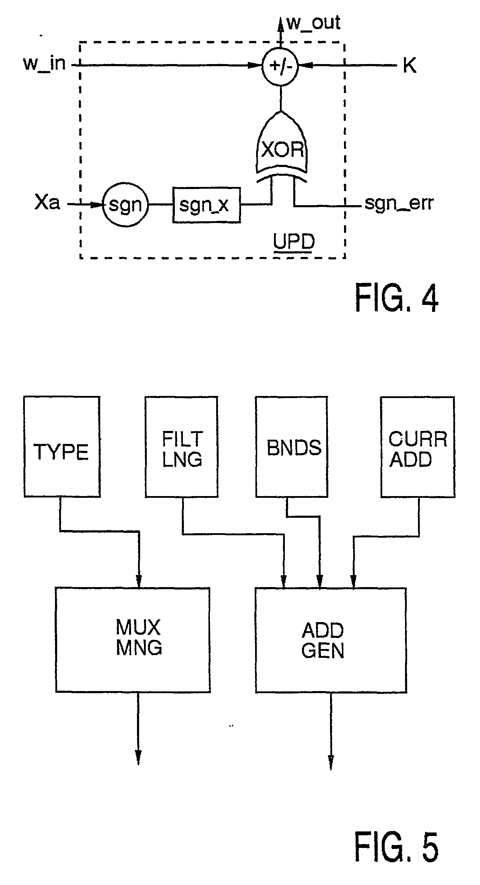

Le bloc de mise à jour UPD, représenté plus en détail par la figure 4, reçoit une donnée "sgn_err", qui est calculée par le processeur hôte dans le cas d'un filtre adaptatif, et il met en oeuvre l'algorithme représenté par l'équation 3. Du fait d'une organisation en pipe-line et du temps de communication entre le co-processeur et le processeur hôte, l'erreur est disponible avec un certain délai, et le signe des données est mémorisé pendant ce temps. Le bloc comprend donc un registre sgn_x pour mémoriser le signe sgn d'une donnée Xa pendant qu'on attend le signe sgn_err de l'erreur à calculer ; il comprend en outre une porte ou-exclusif XOR à deux entrées auxquelles sont amenés, pour créer un bit de signe, respectivement le signe sgn et le signe sgn_err, et dont la sortie est connectée à une entrée d'un additionneur-soustracteur +/- qui reçoit sur une autre entrée une valeur de coefficient w_in issue de la mémoire w-taps, via la connexion 7 de la figure 3, et sur encore une autre entrée une constante K interne au bloc et correspondant au pas d'adaptation. L'additionneursoustracteur délivre une valeur de coefficient w_out à mémoriser dans la mémoire des coefficients.

La figure 3 illustre la progression du calcul, dans l'espace temps, d'un filtre à 4 coefficients w0, w1, w2, w3, avec deux éléments processeurs de filtrage FPEO et FPE1. Un point correspond au calcul d'un coefficient. Le nombre à côté de chaque point indique l'instant du calcul. Un jeu de quatre calculs sont réalisés au même moment par le même élément processeur de filtrage. Une flèche verticale illustre la propagation des résultats y(n), les flèches en diagonale illustrent la progression spatiale des x sous-mots de données. La subdivision en sous-mots ne change pas le calcul d'un résultat, mais seulement la progression des données entre différents résultats de calcul. Plusieurs données sont utilisées à chaque itération (données dans le rectangle gris) ; la première est utilisée par le point en haut à droite, cependant que la dernière correspond au point en bas à gauche. x(dn) est utilisé pour le calcul de y(n) correspondant au point en haut à droite , $x(dn-n_t+1)$ est utilisé pour le calcul de y(n) correspondant au point en bas à droite et $x(d(n-p_x+1))$ est utilisé pour le calcul de $y(n-p_x+1)$ correspondant au point en haut à gauche. Ainsi le nombre de données à lire est $R_p = (p_x-1)d+n_t$. En outre, chaque mot de 32 bits contient $p_x$ données, si bien que le nombre de mots de 32 bits adjacents à lire est de :

$$R_{32} = d + \left[ \frac{1}{P_x} \left( \frac{n_m}{T_c} - d \right) \right]$$

Ainsi le nombre de lectures augmente avec d. Avec deux ports de lecture pour la mémoire x-data, il est possible de réaliser des filtres avec décimation, d'un facteur de deux. Dans le cas de filtres symétriques, deux fois plus de données d'entrée sont utilisées simultanément, si bien que quatre lectures 32 bits sont nécessaires pour la mémoire x-data. Au plus deux coefficients différents sont utilisés simultanément pour chacun des résultats partiels ($n_t$ = 1 ou 2); par conséquent, comme seuls des calculs en précision 16 et 8 bits sont permis, une lecture 32 bits est nécessaire pour la mémoire w-taps ; $p_x$ résultats partiels successifs sont utilisés, si bien qu'une lecture 32 bits est nécessaire pour les registres y-data.

Pour initialiser ou mettre à jour les coefficients, une écriture 32 bits est nécessaire dans la mémoire w-taps ; $p_c$ produits réels successifs sont mémorisés, ainsi une écriture 32 bits est nécessaire pour les registres y-data. Pendant le calcul d'un nouveau jeu de résultats $p_x$, $dp_x$ nouvelles données d'entrée arrivent ; s'il n'y a pas décimation, une écriture 32 bits est nécessaire pour la mémoire x-taps ; dans le cas de filtres à décimation, plusieurs itérations sont nécessaires pour mémoriser les données à cause de la bande passante limitée de la liaison avec le processeur hôte ($p_x$ données à chaque cycle).

Chaque filtre est partagé en plus petits filtres de longueur identique, calculés simultanément de manière systolique ; ainsi, chaque élément processeur de filtrage calcule un filtre ayant les mêmes caractéristiques ; il requiert les mêmes commandes que les autres. Donc un seul bloc de commande suffit quelque soit le nombre d'éléments processeurs de filtrage. Le bloc de commande de la figure 5 comprend quatre registres de taille NMF, où NMF est le nombre maximum de filtres qui peuvent être multiplexés. Ce bloc de commande a plusieurs rôles :

- il mémorise dans un registre "TYPE" les caractéristiques de chaque filtre, telles que le nombre de coefficients,
- il mémorise dans un registre "FILT LNG" les caractéristiques de chaque filtre, telles que le nombre de coefficients,
- il mémorise dans un registre "CURR ADR" les adresses courantes en mémoire, et dans un registre "BDNS" les limites hautes et basses des parties des registres de données et de coefficients qui sont utilisées,
- il engendre grâce à un bloc "ADD GEN" les adresses nécessaires pour les éléments processeurs de filtrage,
- il commande le bloc de réorganisation, ainsi que les communications entre les éléments processeurs de filtrage.

Le bloc de gestion MUX MNG est un circuit de logique combinatoire qui commande les communications de données dans le co-processeur en fonction du type de filtre.

**Revendications**

**1.** Circuit co-processeur programmable destiné à être associé à un processeur principal pour constituer un filtre numérique, circuit comprenant plusieurs éléments processeurs de filtrage commandés par un bloc de commande et contenant chacun un registre de données d'entrée (x-data) dont une sortie de lecture est reliée à une entrée d'au moins un additionneur (1), au moins un multiplieur (3) dont une entrée est connectée à une sortie de résultat de l'additionneur et une autre entrée est connectée à une sortie de lecture d'une mémoire de coefficients (w-taps), et dont une sortie de résultat est reliée à une entrée d'un additionneur (6) dit final dont une sortie fournit un résultat intermédiaire du calcul d'une équation à chaque cycle d'une horloge, **caractérisé en ce que**, pour multiplexer une pluralité de filtres différents ayant différents formats de données et différentes vitesses pour l'entrée des données, chaque élément processeur de filtrage comprend un nombre de registres de résultats partiels (y-data) égal au nombre de filtres différents que l'on désire pouvoir multiplexer, une entrée d'écriture de chaque registre est connectée à la sortie de l'additionneur final (6), et une sortie de lecture de chaque registre est connectée à une des entrées (y-old) de l'additionneur final.

**2.** Circuit co-processeur programmable selon la revendication 1, **caractérisé en ce que** chaque élément processeur de filtrage comprend deux additionneurs qui reçoivent chacun, depuis la mémoire des données d'entrée, deux données d'entrée à additionner.

**3.** Circuit co-processeur programmable selon la revendication 2, **caractérisé en ce qu'**il comporte un bloc de réorganisation de données qui est muni de moyens pour recevoir des données d'entrée depuis la mémoire des données d'entrée, pour les réorganiser et les fournir aux deux additionneurs.

**4.** Circuit co-processeur programmable selon la revendication 2, **caractérisé en ce que** chaque élément processeur de filtrage comprend deux multiplieurs, ayant chacun une entrée connectée à une sortie de résultat d'un des deux additionneurs.

**5.** Circuit co-processeur programmable selon la revendication 4, **caractérisé en ce que** les sorties de chacun des deux multiplieurs sont connectées chacune à une entrée d'un additionneur/soustracteur dont une sortie est connectée à une entrée de l'additionneur final.

**6.** Circuit co-processeur programmable selon la revendication 1, **caractérisé en ce qu'**il comporte un bloc de mise à jour muni de moyens pour traiter des coefficients issus de la mémoire des coefficients et les ré-introduire dans cette mémoire.

**7.** Circuit co-processeur programmable selon la revendication 6, **caractérisé en ce que** le bloc de mise à jour comporte une porte ou-exclusif à deux entrées auxquelles sont amenés respectivement un signal de donnée issu de la mémoire des données et un signal d'erreur issu du processeur principal, et dont une sortie est connectée à une entrée d'un additionneur qui reçoit sur une autre entrée une valeur de coefficient issue de la mémoire des coefficients, et est muni de moyens pour délivrer une valeur de coefficient à mémoriser dans la mémoire des coefficients.

**8.** Circuit co-processeur programmable selon la revendication 1, **caractérisé en ce que** le bloc de commande comprend plusieurs blocs de registres comprenant chacun un nombre de registres égal au nombre de filtres qui peuvent être multiplexés, pour mémoriser des caractéristiques de chaque filtre et des adresses courantes en mémoire.

**Claims**

**1.** A programmable co-processor circuit intended for use in conjunction with a main processor so as to form a digital filter, which circuit comprises a plurality of filter processing elements controlled by a control unit and each including an input data register having a read output connected to an input of at least one adder, at least one multiplier having an input connected to a result output of the adder and having another input connected to a read output of a coefficient memory, and having a result output connected to an input of a final adder having an output which supplies an intermediate result of the calculation of an equation upon each cycle of a clock, **characterized in that**, for multiplexing a plurality of different filters having different data formats and different data input rates, each filter processing element further comprises a number of partial-result registers (y-data), which number is equal to the desired number of filters to be multiplexed, each register has a write input connected to the output of the final adder (6), and each register has a read output connected to one of the inputs (y-old) of the final adder.

2. A programmable co-processor circuit as claimed in claim 1, **characterized in that** each filter processing element comprises two adders which each receive two sets of input data to be added together from the input data memory.

3. A programmable co-processor circuit as claimed in claim 2, **characterized in that** it comprises a data reorganization unit which includes means for receiving input data from the input data memory, in order to reorganize said data and supply said data to the two adders.

4. A programmable co-processor circuit as claimed in claim 2, **characterized in that** each filter processing element includes two multipliers, each having an input connected to a result output of one of the two adders.

5. A programmable co-processor circuit as claimed in claim 4, **characterized in that** the two multipliers each have an output connected to an input of an adder/subtracter which has an output connected to an input of the final adder.

6. A programmable co-processor circuit as claimed in claim 1, **characterized in that** it includes an updating unit having means for processing coefficients obtained from the coefficient memory and re-loading them into this memory.

7. A programmable co-processor circuit as claimed in claim 6, **characterized in that** the updating unit includes an exclusive-or gate having two inputs which respectively receive a data signal from the data memory and an error signal from the main processor, and having an output connected to an input of an adder which receives a coefficient value from the coefficient memory at another input, and includes means for supplying a coefficient value to be stored in the coefficient memory.

8. A programmable co-processor circuit as claimed in claim 1, **characterized in that** the control unit comprises a plurality of register units which each comprise a number of registers equal to the number of filters that can be multiplexed, for storing characteristics of each filter and current memory addresses.


**Patentansprüche**

1. Programmierbare Coprozessor-Schaltung, dafür bestimmt, mit einem Hauptprozessor verbunden zu werden, um einen digitalen Filter zu bilden, eine Schaltung mit mehreren Filter-Prozessor-Elementen, gesteuert von einem Steuerblock, und jeweils mit einem Eingangsdatenregister (x-data), wovon ein Leseausgang verbunden ist mit einem Eingang von mindestens einem Addierer (1), mindestens einem Multiplizierer (3), von dem ein Eingang angeschlossen ist an einen Ergebnisausgang des Addierers und ein anderer Eingang angeschlossen ist an einen Leseausgang eines Koeffizientenspeichers (w-taps) und wovon ein Ergebnisausgang verbunden ist mit einem Eingang eines so genannten Endaddierers (6), wovon ein Ausgang bei jedem Uhrzyklus ein Zwischenergebnis der Berechnung einer Gleichung ausgibt, **dadurch gekennzeichnet, dass** zum Multiplexen einer Vielzahl von verschiedenen Filtern mit verschiedenen Datenformaten und verschiedenen Geschwindigkeiten für den Eingang der Daten jedes Filter-Prozessor-Elements eine Anzahl von Registern mit Teilergebnissen (y-data) gleich der Anzahl der verschiedenen Filter enthält, die man multiplexen können will, wobei ein Schreibeingang jedes Registers an den Ausgang des Endaddierers (6) angeschlossen ist, und ein Leseausgang jedes Registers an einen der Eingänge (y-old) des Endaddierers angeschlossen ist.

2. Programmierbare Coprozessor-Schaltung nach Anspruch 1, **dadurch gekennzeichnet, dass** jedes Filter-Prozessor-Element zwei Addierer enthält, die jeweils vom Speicher der Eingangsdaten zwei zu addierende Eingangsdaten erhalten.

3. Programmierbare Coprozessor-Schaltung nach Anspruch 2, **dadurch gekennzeichnet, dass** sie einen Block zur Reorganisation von Daten enthält, der mit Mitteln für den Erhalt der Eingangsdaten vom Speicher der Eingangsdaten versehen ist, um sie zu reorganisieren und an die zwei Addierer auszugeben.

4. Programmierbare Coprozessor-Schaltung nach Anspruch 2, **dadurch gekennzeichnet, dass** jedes Filter-Prozessor-Element zwei Multiplizierer enthält, mit jeweils einem Eingang, angeschlossen an einen Ergebnisausgang einer der zwei Addierer.

5. Programmierbare Coprozessor-Schaltung nach Anspruch 4, **dadurch gekennzeichnet, dass** die Ausgänge jeder der beiden Multiplizierer jeweils an einen Eingang eines Addierers/Subtrahierers angeschlossen sind, wovon ein Ausgang an einen Eingang des Endaddierers angeschlossen ist.

6. Programmierbare Coprozessor-Schaltung nach Anspruch 1, **dadurch gekennzeichnet, dass** sie einen Aktualisierungsblock enthält, versehen mit Mitteln für die Verarbeitung der Koeffizienten, die aus dem Koeffizientenspeicher kommen, um sie wieder in dieser Speicher einzugeben.

7. Programmierbare Coprozessor-Schaltung nach Anspruch 6, **dadurch gekennzeichnet, dass** der Aktualisierungsblock ein Exklusiv-Oder-Gatter mit zwei Eingängen enthält, dem respektive ein Datensignal kommend aus dem Datenspeicher und ein Fehlersignal aus dem Hauptprozessor zugeführt werden und wovon ein Ausgang an einen Eingang eines Addierers angeschlossen ist, der an einem anderen Eingang einen aus dem Koeffizientenspeicher kommenden Koeffizientenwert erhält und mit Mitteln versehen ist, um einen im Koeffizientenspeicher zu speichernden Koeffizientenwert auszugeben.

8. Programmierbare Coprozessor-Schaltung nach Anspruch 1, **dadurch gekennzeichnet, dass** der Steuerblock mehrere Registerblöcke enthält mit jeweils einer Anzahl an Registern gleich der Anzahl an Filtern, die multiplexiert sein können, um die Charakteristiken jedes Filters und die laufenden Adressen im Speicher zu speichern.

FIG. 1

FIG. 3

FIG. 2

w_out

w_in ———————————————→ (+/-) ←——————— K

XOR

Xa ——→ (sgn) → [sgn_x]

sgn_err

UPD

## FIG. 4

| TYPE | FILT LNG | BNDS | CURR ADD |

| MUX MNG | ADD GEN |

## FIG. 5

**EP 0 926 823 B1**

**Documents brevets cités dans la description**

- EP 0732809 A